Europäisches Patentamt

European Patent Office

Office européen des brevets

(11) Publication number: **0 513 477 A2**

# EUROPEAN PATENT APPLICATION

(21) Application number: **92102436.0**

(22) Date of filing: **13.02.92**

(51) Int. Cl.5: **H04B 1/16**

(30) Priority: **16.05.91 JP 110679/91**

(43) Date of publication of application:
**19.11.92 Bulletin 92/47**

(84) Designated Contracting States:
**DE FR GB**

(71) Applicant: **PIONEER ELECTRONIC CORPORATION**
**No. 4-1, Meguro 1-chome**
**Meguro-ku Tokyo 153(JP)**

(72) Inventor: **Kobayashi, Hideki, Pioneer Electronic Corporation**
**Kawagoe Kojo, 25-1, Aza Nishimachi, Oaza Yamada**
**Kawagoe-shi, Saitama 350(JP)**

(74) Representative: **Reinhard, Skuhra, Weise**
**Friedrichstrasse 31**
**W-8000 München 40(DE)**

(54) Preset type radio receiver.

(57) A preset type radio receiver where broadcasting stations are preset to corresponding channel keys so that a tuner section tunes to a desired station in response to a pressing of a channel key corresponding to the desired station. A quality-of-sound setting section sends a frequency characteristic of an output of the tuner section. The frequency characteristic is set in accordance with a data indicative of the frequency characteristic. A memory stores therein sets of data of the broadcasting stations, each of sets of data being preset to a corresponding channel key. Each of sets of data includes the first data and a frequency data necessary for receiving a broadcasting station. When a channel key is pressed by a user, a controller reads a set of data from the memory and sends the first data of the set of data to the quality-of-sound setting section and the frequency data of the set of data to the tuner section.

F I G. 1

## BACKGROUND OF THE INVENTION

### Field of the Invention

The present invention relates to a preset type radio receiver and more particularly to a preset radio in which a specific output frequency characteristics may be preset to a corresponding station.

### Prior Art

Conventional preset radio receivers have channel selecting keys, each of which is preset to a specific broadcasting station. When a user presses one of the channel selecting keys corresponding to a desired station, the desired station is automatically selected and tuned to.

Radio broadcasting stations usually broadcast particular branches of music such as classical music, jazz, rock-and-roll, and other popular music in order to distinguish them from the other stations. This is particularly true for FM stations. Meanwhile, with stations that are broadcasting strictly educational programs and stations that are exclusively broadcasting traffic information on highways, music is seldom on the air but announcers are speaking most of the time. That is, each of radio stations has its own characters and features. The prior art preset radio receivers are merely adapted to automatically receive the channel specified by a channel key and the user has to adjust the quality of sound of receiver output to his desired characteristics. Thus, it is desirable that a user is allowed to listen to a desired station with preset quality of sound i.e., preset frequency response of the receiver output.

## SUMMARY OF THE INVENTION

The present invention was made in view of the aforementioned drawbacks of the prior art receiver. An object of the invention is to provide a preset radio receiver where channel keys are preset to corresponding stations so that a desired station is automatically tuned in response to a pressing of a corresponding channel key. In the preset type radio receiver according to the invention, when the receiver is tuned to a station, a memory stores corresponding data representing the frequency characteristic of receiver output. The frequency characteristic of receiver output is set by quality-of-sound setting means for respective channel. Quality-of-sound controlling means reads the data of frequency characteristic of receiver output to automatically set the quality-of-sound setting means for the data read out of the memory.

## BRIEF DESCRIPTION OF THE DRAWINGS

Features and other objects of the invention will be more apparent from the description of the preferred embodiments with reference to the accompanying drawings in which:

Fig. 1 shows an embodiment of a preset type radio receiver according to the invention;

Fig. 2 is a front view of the operating panel of the embodiment;

Fig. 3 is a diagram showing an example of presetting a receiver for an FM band; and

Fig. 4 is a diagram showing an example of presetting a receiver for an AM band.

## DETAILED DESCRIPTION OF THE PREFERRED EMBODIMENT

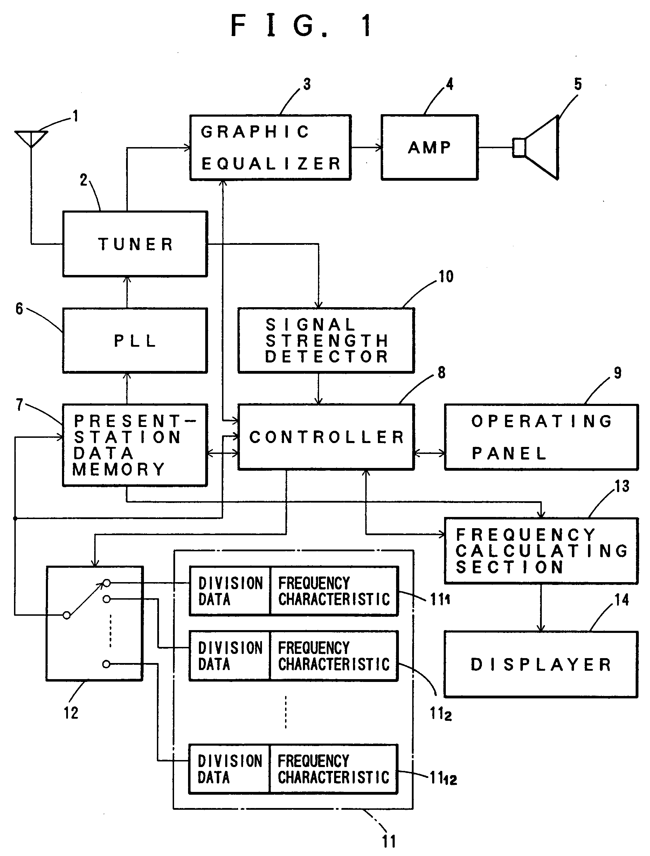

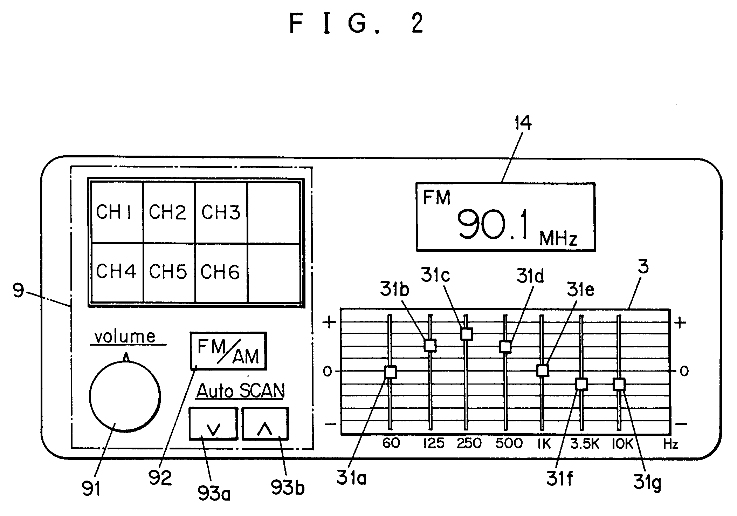

An embodiment of the invention will now be described in detail with reference to the drawings. Fig. 1 is a block diagram showing an embodiment of a preset type radio receiver according to the invention. Fig. 2 is a front view of the operating panel of the receiver in Fig. 1.

In Fig. 2, the adjustment of a volume control knob 91 permits to set the receiver output to a desired sound level. Pressing the FM/AM selector key 92 selects either the FM band or AM band. When the automatic scanning keys 93a or 93b is pressed, the entire frequency band of the receiver is scanned, searching for a station having a usable signal.

The user presses the key 93a to initiate a scanning of preset channels in the descending order and the key 93b in the ascending order. A total of 12 stations to be received are preset to the six channel keys CH1-CH6, each of the keys being assigned one FM station and one AM station.

The graphic equalizer 3 has seven level-adjusting knobs 31a-31ga for adjusting the quality of sound in seven subdivided frequency ranges. Respective knobs are connected to corresponding sound-quality setting circuits. Operating the respective knobs upwardly and downwardly enables the user to set the gain for the corresponding frequency ranges, so that a desired overall frequency characteristic of receiver output is set. In the present invention, the level control may be effected either manually through the knobs 13a-13g or automatically through a later described controller 8. In this embodiment, the level adjusting knobs 31a-13g will remain where they are after they have been adjusted their positions for desired levels of respective subdivided frequency ranges. During automatic reception of a preset station under control of the controller 8, the positions of level control knobs remain unchanged regardless of which station is received, and only the values of electrical components within the graphic equalizer 3 are changed electrically. A displayer 14 is disposed in the middle of the operating panel 9, and displays the frequency band(FM or AM) being received, receiving frequency calculated by the frequency calculating section 13, and other necessary reception information.

Referring to Fig. 1, a tuner 2 incorporates an electronic tuning circuit that varies the tuning frequency of the receiver in accordance with a predetermined corresponding tuning voltage from a PLL(Phase-Locked Loop) 6, so that the tuner 2 selectively receives a desired station incoming through the antenna 1 and converts the radio wave of the desired station into an audio signal. The audio signal is subsequently radiated through the graphic equalizer 3, amplifier 4, and speaker 5.

A controller 8 reads out the division data from a memory 11 and sends it to a present station data memory 7. The present station data memory 7 supplies the PLL 6 with the division data which determines the division of a frequency divider within the PLL 6. The division data determines the output frequency of PLL 6. The PLL 6 locks on a very stable reference frequency such as a crystal oscillator and provides the stable output frequency. The output frequency of PLL is supplied as a local oscillator frequency to the tuner 2. The PLL 6 also provides the aforementioned tuning voltage that corresponds to the output frequency of PLL.

The signal strength detector 10 monitors a signal such as an S-meter signal, which varies in accordance with the field intensity of the signal from the tuner 2, so as to generate a station-detecting signal indicative of the presence and absence of a station currently being received in terms of the level thereof. The controller 8 takes the form of a microcomputer, and monitors the channel keys, FM/AM selector 92, and auto scan buttons on the operating panel 9 and the graphic equalizer 3 to perform later described controls. The controller 8 receives a station-detecting signal from a signal strength detector 10 to read the data indicative of the frequency characteristic corresponding to the received station.

A memory 11 is, for example, a non-volatile RAM having 12 memory areas $11_1$ to $11_{12}$, each of which corresponding to a specific station of 12 receiving stations which have been previously set through the channel keys CH1-CH6. Each of the memory areas $11_1$ to $11_{12}$ stores the division data for specifying a preset station to be received and the corresponding frequency characteristic of receiver output. The controller 8 selects one of the memory areas $11_1$ to $11_{12}$ to read the content of the selected memory area via a switch 12, and sends the content to the present station data memory 7.

A frequency calculating section 13 receives the division data from the memory 7 and calculates the frequency being received on the basis of the division data. The output of frequency calculating section 13 is supplied to the displayer 14 which displays the calculated receiving frequency. The display 14 also displays the frequency band currently selected, i.e., FM or AM, and other necessary reception information.

[Preset Operation]

The preset operation of the stations and the corresponding frequency characteristic of receiver output will now be described with respect to a receiver of the aforementioned construction.

The user first operates the FM/AM selector key 92 to select a desired frequency band, for example, FM. Then, the user operates the automatic scanning key, for example, 93b to initiate automatic scanning of FM stations in the direction of increasing frequency.

When the controller 8 detects a press of the automatic scanning key 93b, the controller 8 clears the division data corresponding to the station currently being received and then sets a division data corresponding to the lowest frequency in the FM band so as to sequentially change the division data in the direction of increasing frequency. Sequentially updating the division data in the present-station data memory 7 causes the output frequency of PLL 6 and the tuning voltage to correspondingly change. This sequentially increases the tuning frequency of the tuner 2.

Meanwhile, the signal strength detector 10 monitors the level of S-meter signal of the tuner 2. If the S-meter signal is above a predetermined level, the circuit 10 outputs to the controller 8 a station detecting signal indicating that a station has been received.

When the controller 8 receives the station detecting signal from the signal strength detector 10, the controller 8 causes the present-station data memory 7 to hold the division data at that time and the tuner 2 to tune to the corresponding station. If the user desires to preset this station currently being received, then the user operates the level adjusting knobs 31a-31g of the graphic equalizer 3 to select desired frequency characteristic of receiver output suitable for classical music, for example.

Then, user presses a channel key to which he wants to preset the station currently being received, e.g., first channel key CH1. In order to assign the station currently being received to CH1, the user presses the first channel key CH1 for a time relatively longer (e.g. three seconds) than when stations are normally selected. This relatively long press of channel key CH1 is detected by the controller 8 which in turn causes the switch 12 to shift to the position of the first memory area $11_1$ corresponding to the channel key CH1.

Then, the controller 8 reads from the present-station-data memory 7 the division data of the station currently being received, and stores it into the first memory area $11_1$. Then, the controller 8 reads the level settings of the subdivided frequency ranges of graphic equalizer 3 from the graphic equalizer 3, and stores the thus read level settings into the first memory area $11_1$. The respective level settings are combined to produce the frequency characteristic.

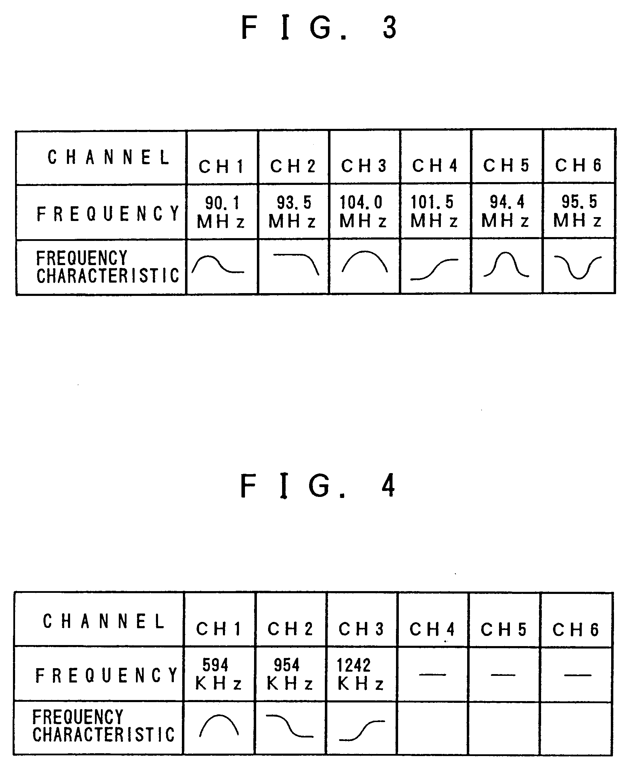

In this manner, as shown in Fig. 3, the first memory area $11_1$ corresponding to the first channel key CH1 is preset thereto the division data that specifies a desired FM station(e.g., 90.1 Mhz in Fig. 3) and the corresponding frequency characteristic thereof.

The above described preset operation is sequentially performed for each of the channels CH1-CH6, so that as shown in Fig. 3, the respective memory areas $11_1$-$11_{12}$ corresponding to the respective channel keys CH1-CH6 are preset thereto the division data of desired FM stations and the corresponding frequency characteristic thereof.

Operating the FM/AM selector key to select the AM band and then performing the aforementioned preset operation, permits the respective memory areas $11_7$-$11_{12}$ corresponding to the respective channel keys CH1-CH6 to be preset the division data of desired AM stations and the desired corresponding frequency characteristic of receiver output.

[Normal reception]

When the user presses the channel key, for example, CH2 of a desired station, the tuner 2 automatically selects the station corresponding to the pressed channel key CH2, while the graphic equalizer 3 is automatically set for the frequency characteristic of receiver output which has been preset to the CH2.

In other word, the controller 8 detects when the channel key CH2 is pressed for a relatively short time(e.g. shorter than three seconds) with the FM/AM selector key 92 positioned at the FM band, and then causes the switch 12 to shift to the position of the second memory area $11_2$ corresponding to the channel, i.e., CH2.

Then, the controller 8 reads from the second memory area $11_2$ the division data that specifies a desired station and transfers the data to the present station data memory 7. The controller 8 also reads the frequency characteristic of receiver output of that station to electrically set automatically the levels of the subdivided frequency ranges of graphic equalizer 3 for the thus read frequency characteristic of receiver output.

The present station data memory 7 supplies the division data to the PLL circuit 6. Thus, the PLL 6 supplies the tuner 2 with a tuning voltage corresponding to the division data supplied to the PLL circuit 9 so as to automatically select an FM station of 93.5 MHz that corresponds to the second channel key CH2 in Fig. 3.

The broadcasting wave of the FM station of 93.5 MHz is converted into an audio frequency signal by the tuner 2, is then tone-controlled by the graphic equalizer 3 in accordance with the frequency characteristic of receiver output, and is radiated from the speaker 5 through the amplifier 4. In this manner, the program may be listened to with an optimum quality of sound suitable for the received station.

While the embodiment has been described with respect to a receiver having a plurality of preset channel keys CH1-CH6, the receiver may be so constructed that a single key is pressed in succession to cyclically select the channel to be received.

Although the graphic equalizer 3 is incorporated within the preset radio receiver, the equalizer 3 may be constructed as a separate unit external to the preset radio receiver. In the aforementioned embodiment, the level adjusting knobs of graphic equalizer 3 remain where they are after the subdivided ranges have been set their levels when a station is being received. Therefore, the frequency characteristic of receiver output of the currently being received is not visually recognized. In this case, an electronic displayer such as LEDs may be used for displaying the levels of subdivided frequency ranges so that the user is able to directly and visually recognize the frequency characteristic of receiver output.

**Claims**

1. A preset type radio receiver where broadcasting stations are preset to corresponding channel keys so that a tuner section tunes to a desired station in response to a pressing of a channel key corresponding to the desired station, comprising:

   quality-of-sound setting means (3) for setting an overall frequency characteristic of an output of the tuner section, said overall frequency characteristic being set in accordance with a first data indicative of said overall frequency characteristic;

   memory means (7) for storing therein sets of data of the broadcasting stations, each of sets of data including said first data and a frequency data necessary for receiving a broadcasting station, each of sets of data corresponding to a specific channel key; and

controlling means (8) for reading said set of data from said memory means and for sending the first data of said set of data to said quality-of-sound setting means and said frequency data of said set of data to the tuner section, said first data and said frequency data being read when said channel key is pressed.

2. A preset type radio receiver according to Claim 1, wherein said broadcasting stations are FM stations.

3. A preset type radio receiver according to Claim 1, wherein said broadcasting stations are AM stations.

4. A preset type radio receiver according to Claim 1, wherein said radio receiver further includes a scanning key for starting search for stations across a frequency band of said tuner section, said control means produces said frequency data and sends it to said memory means when a station is received by said tuner section upon operating said scanning key while at the same time said quality-of-sound setting means produces said first data and sends it to said memory means.

5. A preset type radio receiver according to Claim 2, said overall frequency characteristic has a plurality of subdivided frequency ranges, and said quality-of-sound means has as many level adjusting means as there are said subdivided frequency ranges, each of said knobs corresponding to a specific subdivided frequency range, each of said knobs being adjusted a position of thereof by a user to set a frequency characteristic of the specific subdivided frequency range when a station is received by said tuner section upon operating said scanning key, whereby producing said first data indicative of said overall frequency characteristic.

# F I G .  1

EP 0 513 477 A2

# FIG. 2

# F I G .  3

| C H A N N E L | C H 1 | C H 2 | C H 3 | C H 4 | C H 5 | C H 6 |
|---|---|---|---|---|---|---|
| F R E Q U E N C Y | 90. 1 MH z | 93. 5 MH z | 104. 0 MH z | 101. 5 MH z | 94. 4 MH z | 95. 5 MH z |
| FREQUENCY CHARACTERISTIC | ⌒ | ⌐ | ⌢ | ∫ | ∧ | ⌣ |

# F I G .  4

| C H A N N E L | C H 1 | C H 2 | C H 3 | C H 4 | C H 5 | C H 6 |
|---|---|---|---|---|---|---|
| F R E Q U E N C Y | 594 K H z | 954 K H z | 1242 K H z | — | — | — |
| FREQUENCY CHARACTERISTIC | ⌢ | ⌐ | ∫ | | | |